# FASCICULE DE BREVET EUROPEEN

(11) **EP 4 710 120 B1**
(45) Date de publication et mention de la délivrance du brevet: **28.10.2026**
(21) Numéro de dépôt: 24731626.8
(22) Date de dépôt: 13.05.2024
(51) Int. Cl.: G01R 31/3842, G01R 31/364, H01M 10/42, H01M 10/48

(54) **MODULE POUR DÉTECTER UN NIVEAU DE CHARGE DE BATTERIE, ENSEMBLE COMPRENANT LE MODULE ET AÉRONEF COMPRENANT L'ENSEMBLE**
MODUL ZUR ERKENNUNG EINES BATTERIELADEZUSTANDS, ANORDNUNG MIT DEM MODUL UND FLUGZEUG MIT DER ANORDNUNG
MODULE FOR DETECTING A BATTERY LEVEL OF CHARGE, ASSEMBLY COMPRISING THE MODULE, AND AIRCRAFT COMPRISING THE ASSEMBLY

(30) Priorité: 09.05.2023 FR 2304612
(43) Date de publication de la demande: 18.03.2026
(73) Titulaire: Safran Electrical & Power, 31702 Blagnac Cedex (FR)
(72) Inventeur: GUILLARD, Eric, 77550 MOISSY-CRAMAYEL (FR)
(74) Mandataire: Ernest Gutmann - Yves Plasseraud S.A.S.
(86) Numéro de dépôt international: PCT/FR2024/050610
(87) Numéro de publication internationale: WO 2024/231643

(56) Documents cités:
- WO-A1-2020/179479
- JP-A- 2010 225 449
- JP-A- 2013 174 555
- US-A1- 2016 254 515

## Description

### Domaine de la divulgation

La présente divulgation concerne un module pour détecter un niveau de charge de batterie, un ensemble comprenant le module et la batterie, ainsi qu'un aéronef comprenant l'ensemble et un groupe motopropulseur électriquement alimenté par la batterie.

### Etat de la technique

La détermination du niveau de charge d'une batterie est souvent utile, notamment dans le cas où la batterie alimente électriquement le groupe motopropulseur d'un aéronef. Il est connu pour déterminer la charge de la batterie de brancher un voltmètre aux bornes de la batterie, de disposer un ampèremètre entre l'une des bornes de la batterie et une charge branchée sur la batterie et de mesurer la température.

La présente divulgation vise à améliorer la précision et la robustesse de mesure de la charge de la batterie, faciliter l'intégration de cette mesure dans un ensemble distribuant l'énergie électrique de la batterie, tout en minimisant le risque de défaillance. US 2016/254515 A1 divulgue l'attachement d'un module de câblage, dans lequel les barres de bus sont maintenues intégralement par des membres de retenue en résine isolante, à une pluralité de cellules électriques à la fois.

### Exposé de la divulgation

Dans ce but, conformément à la présente divulgation, il est proposé un module pour détecter un niveau de charge de batterie comprenant un boitier et un sous-ensemble, ledit sous-ensemble comprend un ampèremètre, un voltmètre et un capteur de température, dans lequel :
le boitier est destiné à être fixé sur une première barre d'interconnexion et une deuxième barre d'interconnexion alimentées par une batterie, le sous-ensemble est maintenu sur le boitier,
l'ampèremètre comporte un magnétomètre et un dispositif de mesure de courant, le magnétomètre est électriquement relié au dispositif de mesure de courant et le dispositif de mesure de courant est configuré pour transmettre un signal de courant fonction du courant détecté par le magnétomètre,
le voltmètre comporte une première borne de contact, une deuxième borne de contact et un dispositif de mesure de tension, la première borne de contact et la deuxième borne de contact sont chacune électriquement reliées au dispositif de mesure de tension, le dispositif de mesure de tension est configuré pour transmettre un signal de tension fonction de la différence de potentiel entre la première borne de contact et la deuxième borne de contact,
le capteur de température est configuré pour transmettre un signal de température fonction de la température,
le boitier présente un logement dans lequel est reçu le magnétomètre, le logement est destiné à être reçu dans un trou de mesure de la première barre d'interconnexion, le logement présente une surface extérieure électriquement isolante,
le module comprend en outre un premier organe de fixation et un deuxième organe de fixation, le premier organe de fixation est configuré pour fixer le boitier sur la première barre d'interconnexion et maintenir la première borne de contact électriquement au contact de la première barre d'interconnexion, le deuxième organe de fixation est configuré pour fixer le boitier sur la deuxième barre d'interconnexion et maintenir la deuxième borne de contact électriquement au contact de la deuxième barre d'interconnexion.

Ainsi, le module peut être entièrement réalisé et testé avant son raccordement à la batterie.

Selon une autre caractéristique conforme à la présente divulgation, de préférence le module comprend en outre un microcontrôleur, le microcontrôleur est électriquement relié à l'ampèremètre, au voltmètre et au capteur de température afin de recevoir le signal de courant, le signal de tension et le signal de température, le microcontrôleur est configuré pour émettre un signal de sortie fonction du signal de courant, du signal de tension et du signal de température.

Selon une caractéristique complémentaire, le signal de sortie comprend de manière successive (multiplexée) le signal de courant, le signal de tension et le signal de température.

Selon une autre caractéristique conforme à la présente divulgation, de préférence le module comprend en outre un connecteur, le connecteur est maintenu sur le boitier et le connecteur est électriquement relié au microcontrôleur afin de recevoir le signal de sortie.

Ainsi, le boitier peut être rapidement connecté pour transmettre des informations pour déterminer le niveau de charge de la batterie.

Selon une autre caractéristique conforme à la présente divulgation, de préférence le boitier présente un espace interne renfermant l'ampèremètre, le voltmètre et le capteur de température.

Ainsi, le boitier réalise la ségrégation entre la haute tension et la basse tension, la haute tension étant extérieure au boitier.

Selon encore une autre caractéristique conforme à la divulgation, le logement est de préférence formé par une portion tubulaire en matériau électriquement isolant.

Ainsi, le boitier est simple à réaliser, le magnétomètre peut être aisément inséré dans le trou de mesure et le magnétomètre est efficacement protégé mécaniquement et isolé électriquement de la première barre d'interconnexion.

Le module présente en outre de préférence les caractéristiques suivantes :
le sous-ensemble forme un premier sous-ensemble (l'ampèremètre forme un premier ampèremètre, le magnétomètre forme un premier magnétomètre, le dispositif de mesure de courant forme un premier dispositif de mesure de courant, le signal de courant forme un premier signal de courant, le voltmètre forme un premier voltmètre, la première borne de contact forme une première borne de premier contact, la deuxième borne de contact forme une deuxième borne de premier contact, le dispositif de mesure de tension forme un premier dispositif de mesure de tension, le signal de tension forme un premier signal de tension, le capteur de température forme un premier capteur de température, le signal de température forme un premier signal de température, le signal de sortie forme un premier signal de sortie, le logement forme un premier logement, le trou de mesure forme un premier trou de mesure, la surface extérieure forme une première surface extérieure, le premier organe de fixation forme un premier organe de première fixation et le deuxième organe de fixation forme un deuxième organe de première fixation),
le module comprend un deuxième sous-ensemble distinct du premier sous-ensemble, le deuxième sous-ensemble est maintenu sur le boitier et comprend un deuxième ampèremètre, un deuxième voltmètre et un deuxième capteur de température,
le deuxième ampèremètre comporte un deuxième magnétomètre et un deuxième dispositif de mesure de courant, le deuxième magnétomètre est électriquement relié au deuxième dispositif de mesure de courant et le deuxième dispositif de mesure de courant est configuré pour transmettre un deuxième signal de courant fonction du courant détecté par le deuxième magnétomètre,
le deuxième voltmètre comporte une première borne de deuxième contact, une deuxième borne de deuxième contact et un deuxième dispositif de mesure de tension, la première borne de deuxième contact et la deuxième borne de deuxième contact sont chacune électriquement reliées au deuxième dispositif de mesure de tension, le deuxième dispositif de mesure de tension est configuré pour transmettre un deuxième signal de tension fonction de la différence de potentiel entre la première borne de deuxième contact et la deuxième borne de deuxième contact,
le deuxième capteur de température est configuré pour transmettre un deuxième signal de température fonction de la température,
le boitier présente un deuxième logement dans lequel est reçu le deuxième magnétomètre, le deuxième logement est destiné à être reçu dans un deuxième trou de mesure de la deuxième barre d'interconnexion, le deuxième logement présente une deuxième surface extérieure électriquement isolante, et
le module comprend en outre un premier organe de deuxième fixation et un deuxième organe de deuxième fixation, le premier organe de deuxième fixation est configuré pour fixer le boitier sur la première barre d'interconnexion et maintenir la première borne de deuxième contact électriquement au contact de la première barre d'interconnexion, le deuxième organe de deuxième fixation est configuré pour fixer le boitier sur la deuxième barre d'interconnexion et maintenir la deuxième borne de deuxième contact électriquement au contact de la deuxième barre d'interconnexion.

Ainsi, sans compliquer la fixation ni le raccordement électrique, le module propose un double système de mesure permettant de fournir des informations pour déterminer le niveau de charge de la batterie, de sorte que si l'un des systèmes est défaillant les informations pour déterminer le niveau de charge peuvent toujours être fournies par l'autre.

La présente divulgation concerne en outre un ensemble comprenant, outre le module précité, la première barre d'interconnexion et la deuxième barre d'interconnexion. L'ensemble présente les caractéristiques suivantes :
la première barre d'interconnexion comporte le trou de mesure, dans lequel est disposé le magnétomètre, le logement est disposé entre le magnétomètre et la première barre d'interconnexion,
le premier organe de fixation fixe le boitier sur la première barre d'interconnexion et maintient la première borne de contact au contact de la première barre d'interconnexion, et
le deuxième organe de fixation fixe le boitier sur la deuxième barre d'interconnexion et maintient la deuxième borne de contact au contact de la deuxième barre d'interconnexion.

La fixation du module à la première barre d'interconnexion et à la deuxième barre d'interconnexion crée le raccordement électrique du module à la première barre d'interconnexion et à la deuxième barre d'interconnexion, de sorte que le raccordement à la batterie est rapide et présente un risque d'aléa faible.

Dans divers modes de réalisation de l'ensemble selon la divulgation, on peut éventuellement avoir recours en outre à l'une et/ou à l'autre des dispositions suivantes :
le premier organe de fixation comprend une première vis de fixation comportant une première tête de vis et une première portion filetée, la première portion filetée est vissée dans la première barre d'interconnexion et la première borne de contact est pressée entre la première tête de vis et la première barre d'interconnexion, le deuxième organe de fixation comprend une deuxième vis de fixation comportant une deuxième tête de vis et une deuxième portion filetée, la deuxième portion filetée est vissée dans la deuxième barre d'interconnexion et la deuxième borne de contact est pressée entre la deuxième tête de vis et la deuxième barre d'interconnexion ;
l'ensemble comprend en outre la batterie, la batterie comprend une première borne et une deuxième borne, la première borne est électriquement reliée à la première barre d'interconnexion et la deuxième borne est électriquement reliée à la deuxième barre d'interconnexion.

La divulgation concerne également un aéronef comprenant, outre l'ensemble précité, un organe de commande et un groupe motopropulseur électriquement alimenté par la batterie, par l'intermédiaire de l'organe de commande.

L'aéronef répond ainsi aux exigences aéronautiques fortes en matière de fiabilité et sécurité.

### Brève description des figures

D'autres caractéristiques et avantages de la présente divulgation apparaîtront dans la description détaillée suivante, se référant aux dessins annexés dans lesquels :
[Fig. 1] représente schématiquement un aéronef comprenant un ensemble et un groupe motopropulseur,
[Fig. 2] représente schématiquement l'ensemble comprenant un module, une première barre d'interconnexion et une deuxième barre d'interconnexion,
[Fig 3] est une vue en coupe selon la ligne repérée III-III à la figure 1,
[Fig 4] est une vue en coupe selon la ligne repérée IV-IV à la figure 1.

### Description détaillée de la divulgation

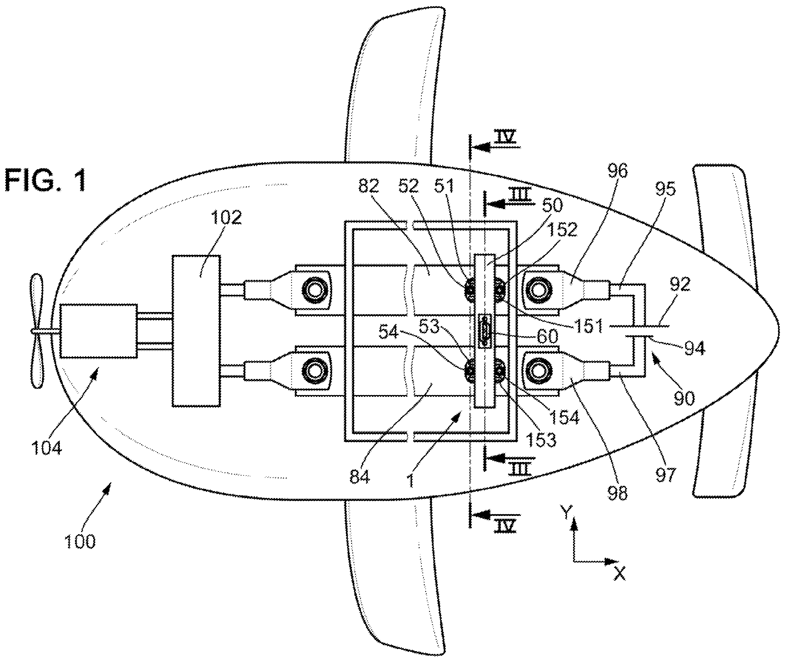

Les figures 1 à 4 illustrent un aéronef 100 comprenant un ensemble 80, un organe de commande 102 et un groupe motopropulseur 104.

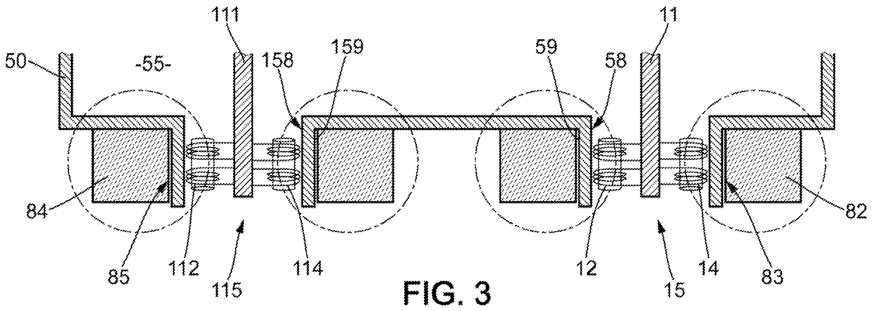

Tel qu'illustré en particulier aux figures 1 et 3, l'ensemble 80 comprend un module 1, une première barre d'interconnexion 82, une deuxième barre d'interconnexion 84 et une batterie 90. La première barre d'interconnexion 82 et la deuxième barre d'interconnexion 84 s'étendent sensiblement suivant une direction longitudinale X. La première barre d'interconnexion 82 présente un premier trou de mesure 83. Le premier trou de mesure 83 est cylindrique, de section circulaire, de préférence débouchant, et réalisé sensiblement au milieu de la première barre d'interconnexion 82, suivant une direction transversale Y perpendiculaire à la direction longitudinale X. Le premier trou de mesure 83 s'étend perpendiculairement à la direction longitudinale X et à la direction transversale Y. La deuxième barre d'interconnexion 84 présente un deuxième trou de mesure 85. Le deuxième trou de mesure 85 est cylindrique, de section circulaire, de préférence débouchant, et réalisé sensiblement au milieu de la deuxième barre d'interconnexion 84, suivant la direction transversale Y. Le deuxième trou de mesure 85 s'étend perpendiculairement à la direction longitudinale X et à la direction transversale Y.

La batterie 90 comprend une première borne 92 et une deuxième borne 94. La première borne 92 est électriquement reliée à la première barre d'interconnexion 82 par l'intermédiaire d'un premier fil d'entrée 95 et d'une première cosse d'entrée 96. La deuxième borne 94 est électriquement reliée à la deuxième barre d'interconnexion 84 par l'intermédiaire d'un deuxième fil d'entrée 97 et d'une deuxième cosse d'entrée 98. La première barre d'interconnexion 82 et la deuxième barre d'interconnexion 84 comprennent chacune de préférence des couches de cuivre, ou du moins d'un matériau électriquement conducteur, séparées par de fins matériaux diélectriques, laminés en un élément monobloc.

Le groupe motopropulseur 104 comprend un moteur électrique et une hélice. L'organe de commande 102 est relié d'une part à la première barre d'interconnexion 82 par une première cosse de sortie et un premier fil de sortie et d'autre part à la deuxième barre d'interconnexion 84 par une deuxième cosse de sortie et un deuxième fil de sortie. L'organe de commande 102 est relié au moteur électrique par un premier fil électrique d'alimentation et un deuxième fil électrique d'alimentation.

Le module 1 comprend un boitier 50, un connecteur 60, un premier sous-ensemble 70 et un deuxième sous-ensemble 170. Le boitier 50 est réalisé en matériau électriquement isolant, en particulier en matériau plastique. Le boitier 50 présente un espace interne 55 délimité par les parois du boitier.

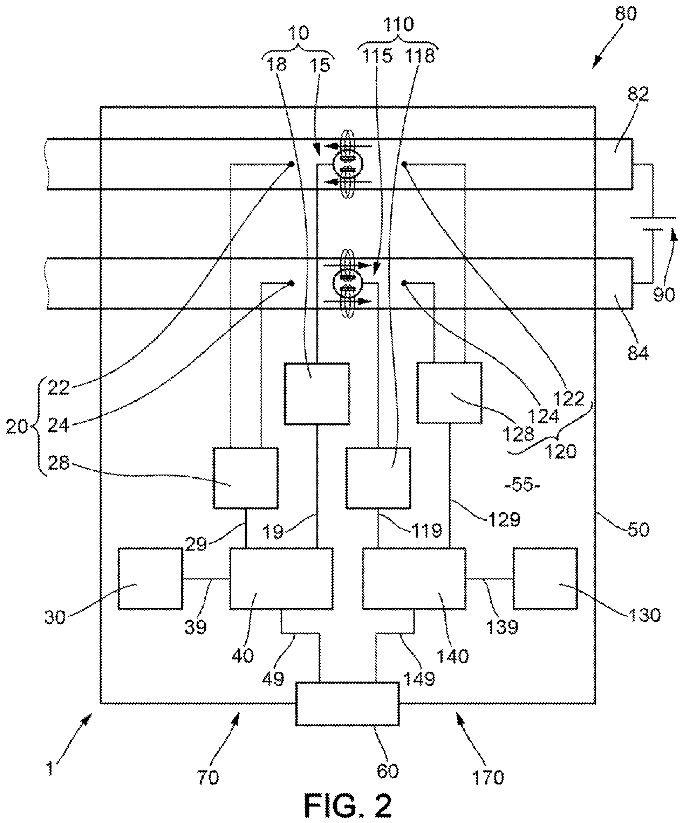

Le premier sous-ensemble 70 est disposé dans l'espace interne 55 maintenu dans le boitier 50 et comprend un premier ampèremètre 10, un premier voltmètre 20, un premier capteur de température 30 et un premier microcontrôleur 40, tel qu'illustré en particulier à la figure 2.

Le premier ampèremètre 10 comporte un premier magnétomètre 15 et un premier dispositif de mesure de courant 18. Tel qu'illustré en particulier à la figure 3, le premier magnétomètre 15 comprend un premier capteur de premier champ magnétique 12 et un deuxième capteur de premier champ magnétique 14. Le premier capteur de premier champ magnétique 12 et le deuxième capteur de premier champ magnétique 14 sont maintenus sur une première carte de circuit imprimé 11. Le premier magnétomètre 15 est disposé dans le premier trou de mesure 83. La circulation de courant dans la première barre d'interconnexion 82 de part et d'autre du premier trou de mesure 83 génère des champs magnétiques qui sont détectés par le premier capteur de premier champ magnétique 12 et le deuxième capteur de premier champ magnétique 14. Le premier capteur de premier champ magnétique 12 et le deuxième capteur de premier champ magnétique 14 sont électriquement reliés au premier dispositif de mesure de courant 18. Le premier dispositif de mesure de courant 18 est de préférence disposé sur la première carte de circuit imprimé 11. Le premier dispositif de mesure de courant 18 transmet un premier signal de courant 19 fonction du champ magnétique généré par le courant circulant dans la première barre d'interconnexion 82 et détecté par le premier magnétomètre 15. Le premier ampèremètre 10 est en particulier du type commercialisé par Texas Instrument^{®} sous la référence DRV425.

Le premier voltmètre 20 comporte une première borne de premier contact 22, une deuxième borne de premier contact 24 et un premier dispositif de mesure de tension 28. La première borne de premier contact 22 et la deuxième borne de premier contact 24 sont chacune électriquement reliées au premier dispositif de mesure de tension 28. Le premier dispositif de mesure de tension 28 est configuré pour transmettre un premier signal de tension 29 fonction de la différence de potentiel entre la première borne de premier contact 22 et la deuxième borne de premier contact 24.

Le premier capteur de température 30 est configuré pour transmettre un premier signal de température 39 fonction de la température dans l'espace interne 55 où est situé le premier capteur de température 30.

Le premier microcontrôleur 40 est électriquement relié au premier ampèremètre 10, au premier voltmètre 20 et au premier capteur de température 30, afin de recevoir le premier signal de courant 19, le premier signal de tension 29 et le premier signal de température 39. Le premier microcontrôleur 40 est configuré pour émettre, vers le connecteur 60, un premier signal de sortie 49 en fonction du premier signal de courant 19, du premier signal de tension 29 et du premier signal de température 39. Plus précisément, le premier microcontrôleur 40 comprend de préférence un bus de données, en particulier un bus de données de type CAN (Controller Area Network) afin transmettre successivement (de manière multiplexée) le premier signal de courant 19, le premier signal de tension 29 et le deuxième signal de température 39, éventuellement recalibrés. En variante, le premier microcontrôleur 40 pourrait déterminer le niveau de charge de la batterie 90 à partir du premier signal de courant 19, du premier signal de tension 29 et du premier signal de température 39, de sorte que le premier signal de sortie 49 contiendrait une information du niveau de charge de la batterie 90.

Le deuxième sous-ensemble 170 est maintenu dans le boitier 50 et comprend un deuxième ampèremètre 110, un deuxième voltmètre 120, un deuxième capteur de température 130 et un deuxième microcontrôleur 140, tel qu'illustré en particulier à la figure 2.

Le deuxième ampèremètre 110 comporte un deuxième magnétomètre 115 et un deuxième dispositif de mesure de courant 118. Tel qu'illustré en particulier à la figure 3, le deuxième magnétomètre 115 comprend un premier capteur de deuxième champ magnétique 112 et un deuxième capteur de deuxième champ magnétique 114. Le premier capteur de deuxième champ magnétique 112 et le deuxième capteur de deuxième champ magnétique 114 sont maintenus sur une deuxième carte de circuit imprimé 111. Le deuxième magnétomètre 115 est disposé dans le deuxième trou de mesure 85. La circulation de courant dans la deuxième barre d'interconnexion 84 de part et d'autre du deuxième trou de mesure 85 génère des champs magnétiques qui sont détectés par le premier capteur de deuxième champ magnétique 112 et le deuxième capteur de deuxième champ magnétique 114. Le premier capteur de deuxième champ magnétique 112 et le deuxième capteur de deuxième champ magnétique 114 sont électriquement reliés au deuxième dispositif de mesure de courant 118. Le deuxième dispositif de mesure de courant 118 est de préférence disposé sur la deuxième carte de circuit imprimé 111. Le deuxième dispositif de mesure de courant 118 transmet un deuxième signal de courant 119 fonction du champ magnétique généré par le courant circulant dans la deuxième barre d'interconnexion 84 et détecté par le deuxième magnétomètre 115. Le deuxième ampèremètre 110 est de préférence identique au premier ampèremètre 10.

Le deuxième voltmètre 20 comporte une première borne de deuxième contact 122, une deuxième borne de deuxième contact 124 et un deuxième dispositif de mesure de tension 128. La première borne de deuxième contact 122 et la deuxième borne de deuxième contact 124 sont chacune électriquement reliées au deuxième dispositif de mesure de tension 128. Le deuxième dispositif de mesure de tension 128 est configuré pour transmettre un deuxième signal de tension 129 fonction de la différence de potentiel entre la première borne de deuxième contact 122 et la deuxième borne de deuxième contact 124.

Le deuxième capteur de température 130 est configuré pour transmettre un deuxième signal de température 139 fonction de la température dans l'espace interne 55 où est situé le deuxième capteur de température 130.

Le deuxième microcontrôleur 140 est électriquement relié au deuxième ampèremètre 110, au deuxième voltmètre 120 et au deuxième capteur de température 130, afin de recevoir le deuxième signal de courant 119, le deuxième signal de tension 129 et le deuxième signal de température 139. Le deuxième microcontrôleur 140 est configuré pour émettre, vers le connecteur 60, un deuxième signal de sortie 149 en fonction du deuxième signal de courant 119, du deuxième signal de tension 129 et du deuxième signal de température 139. Plus précisément, le deuxième microcontrôleur 140 comprend de préférence un bus de données, en particulier un bus de données de type CAN (Controller Area Network) afin transmettre successivement (de manière multiplexée) le deuxième signal de courant 119, le premier signal de tension 129 et le deuxième signal de température 139. En variante, le deuxième microcontrôleur 140 pourrait déterminer le niveau de charge de la batterie 90 à partir du deuxième signal de courant 119, du deuxième signal de tension 129 et du deuxième signal de température 139, de sorte que le deuxième signal de sortie 149 contiendrait une information du niveau de charge de la batterie 90.

Tel qu'illustré en particulier à la figure 3, le boitier 50 comprend un premier logement 58 et un deuxième logement 56. Le premier logement 58 est tubulaire de section circulaire, s'étend perpendiculairement à la direction longitudinale X et à la direction transversale Y et présente une première surface extérieure 59 de section circulaire. Le premier logement 58 est étroitement reçu dans le premier trou de mesure 83, la première surface extérieure 59 s'étendant sensiblement au contact de la première barre d'interconnexion 82, afin de positionner le premier magnétomètre 15 par rapport au premier trou de mesure 83 suivant la direction longitudinale X et la direction transversale Y. Le premier logement 58 traverse entièrement la première barre d'interconnexion 82, afin d'éviter un contact électrique inopiné entre la première barre d'interconnexion 82 et le premier magnétomètre 15. Le deuxième logement 56 est tubulaire de section circulaire, s'étend perpendiculairement à la direction longitudinale X et à la direction transversale Y et présente une deuxième surface extérieure 57 de section circulaire. Le deuxième logement 56 est étroitement reçu dans le deuxième trou de mesure 85, la deuxième surface extérieure 57 s'étendant sensiblement au contact de la deuxième barre d'interconnexion 84, afin de positionner le deuxième magnétomètre 115 par rapport au deuxième trou de mesure 85 suivant la direction longitudinale X et à la direction transversale Y. Le deuxième logement 56 traverse entièrement la deuxième barre d'interconnexion 84, afin d'éviter un contact électrique inopiné entre la deuxième barre d'interconnexion 84 et le deuxième magnétomètre 115.

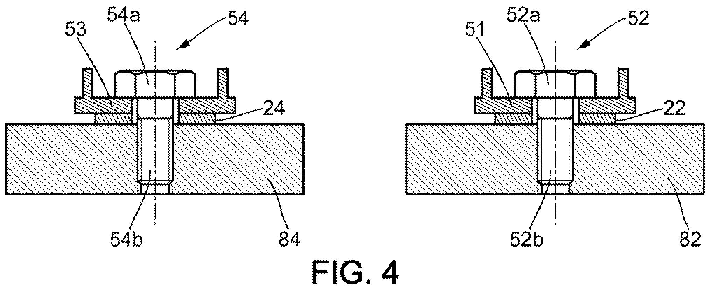

Tel qu'illustré en particulier aux figures 1 et 4, le module 1 comprend en outre un premier organe de première fixation 52 et un deuxième organe de première fixation 54, le premier organe de première fixation 52 fixe le boitier 50 sur la première barre d'interconnexion 82. Le premier organe de première fixation 82 comprend une première vis de première fixation présentant une première tête de vis 52a et une première portion filetée 52b. La première portion filetée 52b est vissée dans la première barre d'interconnexion 82. Le boitier 50 présente une première patte de première fixation 51. La première patte de première fixation 51 est serrée entre la première tête de vis 52a et la première barre d'interconnexion 82. La première borne de premier contact 22 est pressée entre la première tête de vis 52a et la première barre d'interconnexion 82. Dans le mode de réalisation illustré, la première borne de premier contact 22 est disposé entre la première patte de première fixation 51 et la première barre d'interconnexion 82, de sorte que la première borne de premier contact 22 est directement au contact de la première barre d'interconnexion 82. En variante, la première borne de premier contact 22 pourrait être disposée entre la première tête de vis 52a et la première patte de première fixation 51, la connexion électrique entre la première borne de premier contact 22 et la première barre d'interconnexion 82 s'effectuant alors par l'intermédiaire de la première vis de première fixation 51.

Le deuxième organe de première fixation 52 comprend une deuxième vis de première fixation présentant une deuxième tête de vis 54a et une deuxième portion filetée 54b. La deuxième portion filetée 54b est vissée dans la deuxième barre d'interconnexion 84. Le boitier 50 présente une deuxième patte de première fixation 53. La deuxième patte de première fixation 53 est serrée entre la deuxième tête de vis 54a et la deuxième barre d'interconnexion 84. La deuxième borne de premier contact 24 est pressée entre la deuxième tête de vis 54a et la deuxième barre d'interconnexion 84. Dans le mode de réalisation illustré, la deuxième borne de premier contact 24 est disposé entre la deuxième patte de première fixation 53 et la deuxième barre d'interconnexion 84, de sorte que la deuxième borne de premier contact 24 est directement au contact de la deuxième barre d'interconnexion 84 En variante, la deuxième borne de premier contact 24 pourrait être disposée entre la deuxième tête de vis 54a et la deuxième patte de première fixation 53, la connexion électrique entre la deuxième borne de premier contact 24 et la deuxième barre d'interconnexion 84 s'effectuant alors par l'intermédiaire de la deuxième vis de fixation.

Tel qu'illustré en particulier à la figure 1, le module 1 comprend en outre un premier organe de deuxième fixation 152 et un deuxième organe de deuxième fixation 154, et le boitier 50 comprend en outre une première patte de deuxième fixation 151 et une deuxième patte de deuxième fixation 153. Le premier organe de deuxième fixation 152 fixe la première patte de deuxième fixation 151 sur la première barre d'interconnexion 82 et le deuxième organe de deuxième fixation 152 fixe la deuxième patte de deuxième fixation 153 sur la deuxième barre d'interconnexion 84. La première patte de première fixation 51 et la première patte de deuxième fixation 153 sont disposés de part et d'autre du boitier 50. La deuxième patte de première fixation 53 et la deuxième patte de deuxième fixation 153 sont disposés de part et d'autre du boitier 50. Le premier organe de deuxième fixation 152 est analogue au premier organe de première fixation 52. Le premier organe de deuxième fixation 152 maintient la première patte de deuxième fixation 151 sur la première barre d'interconnexion 82 et maintient le contact électrique de la première borne de deuxième contact 122 avec la première barre d'interconnexion 82, de manière analogue à ce qui a décrit supra en relation avec le premier organe de première fixation 52. Le deuxième organe de deuxième fixation 154 est analogue au deuxième organe de première fixation 54. Le deuxième organe de deuxième fixation 154 maintient la deuxième patte de deuxième fixation 153 sur la deuxième barre d'interconnexion 84 et maintient le contact électrique de la deuxième borne de deuxième contact 124 avec la deuxième barre d'interconnexion 84, de manière analogue à ce qui a décrit supra en relation avec le deuxième organe de première fixation 54.

L'organe de commande 102 est relié au module 1 par le connecteur 60. Ainsi, l'organe de commande 102 reçoit du premier sous-ensemble 70 des premières informations pour déterminer le niveau de charge de la batterie 90, à savoir le courant dans la première barre d'interconnexion 82 détectée par le premier ampèremètre 10, la différence de potentiel entre la première barre d'interconnexion 82 et la deuxième barre d'interconnexion 84 détectée par le premier voltmètre 20 et la température détectée par le premier capteur de température 30. L'organe de commande 102 détermine alors un premier niveau de charge de la batterie 90. En variante, l'organe de commande 102 reçoit du premier sous-ensemble 70 l'information d'un premier niveau de charge de la batterie 90.

L'organe de commande 102 reçoit du deuxième sous-ensemble 170 des deuxièmes informations pour déterminer le niveau de charge de la batterie 90, à savoir le courant dans la deuxième barre d'interconnexion 84 détectée par le deuxième ampèremètre 110, la différence de potentiel entre la première barre d'interconnexion 82 et la deuxième barre d'interconnexion 84 détectée par le deuxième voltmètre 120 et la température détectée par le deuxième capteur de température 130. L'organe de commande 102 détermine alors un deuxième niveau de charge de la batterie 90. En variante, l'organe de commande 102 reçoit du premier sous-ensemble 70 l'information d'un deuxième niveau de charge de la batterie 90.

## Revendications

1. Module (1) pour détecter un niveau de charge de batterie comprenant un boitier (50) et un sous-ensemble (70), ledit sous-ensemble comprend un ampèremètre (10), un voltmètre (20) et un capteur de température (30), dans lequel :
le boitier (50) est destiné à être fixé sur une première barre d'interconnexion (82) et une deuxième barre d'interconnexion (84) alimentées par une batterie (90), le sous-ensemble (70) est maintenu sur le boitier (50),
l'ampèremètre (10) comporte un magnétomètre (15) et un dispositif de mesure de courant (18), le magnétomètre (15) est électriquement relié au dispositif de mesure de courant (18) et le dispositif de mesure de courant (18) est configuré pour transmettre un signal de courant (19) fonction du courant détecté par le magnétomètre (15),
le voltmètre (20) comporte une première borne de contact (22), une deuxième borne de contact (24) et un dispositif de mesure de tension (28), la première borne de contact (22) et la deuxième borne de contact (24) sont chacune électriquement reliées au dispositif de mesure de tension (28), le dispositif de mesure de tension (28) est configuré pour transmettre un signal de tension (29) fonction de la différence de potentiel entre la première borne de contact (22) et la deuxième borne de contact (24),
le capteur de température (30) est configuré pour transmettre un signal de température (39) fonction de la température,
le boitier (50) présente un logement (58) dans lequel est reçu le magnétomètre (15), le logement (58) est destiné à être reçu dans un trou de mesure (83) de la première barre d'interconnexion (82), le logement (58) présente une surface extérieure (59) électriquement isolante,
le module (1) comprend en outre un premier organe de fixation (52) et un deuxième organe de fixation (54), le premier organe de fixation (52) est configuré pour fixer le boitier (50) sur la première barre d'interconnexion (82) et maintenir la première borne de contact (22) électriquement au contact de la première barre d'interconnexion (82), le deuxième organe de fixation (54) est configuré pour fixer le boitier (50) sur la deuxième barre d'interconnexion (84) et maintenir la deuxième borne de contact (24) électriquement au contact de la deuxième barre d'interconnexion (84).

2. Module selon la revendication 1 dans lequel le module (1) comprend en outre un microcontrôleur (40), le microcontrôleur (40) est électriquement relié à l'ampèremètre (10), au voltmètre (20) et au capteur de température (30) afin de recevoir le signal de courant (19), le signal de tension (29) et le signal de température (39), le microcontrôleur (40) est configuré pour émettre un signal de sortie (49) fonction du signal de courant (19), du signal de tension (29) et du signal de température (39).

3. Module selon la revendication précédente dans lequel le module (1) comprend en outre un connecteur (60), le connecteur (60) est maintenu sur le boitier (50) et le connecteur (60) est électriquement relié au microcontrôleur (40) afin de recevoir le signal de sortie (49).

4. Module selon l'une quelconque des revendications précédentes dans lequel le boitier (50) présente un espace interne (55) renfermant l'ampèremètre (10), le voltmètre (20) et le capteur de température (30).

5. Module selon l'une quelconque des revendications précédentes dans lequel le logement (58) est formé par une portion tubulaire en matériau électriquement isolant.

6. Module selon l'une quelconque des revendications précédentes dans lequel :
le sous-ensemble forme un premier sous-ensemble,
le module (1) comprend un deuxième sous-ensemble (170) distinct du premier sous-ensemble (70), le deuxième sous-ensemble (170) est maintenu sur le boitier (50) et comprend un deuxième ampèremètre (110), un deuxième voltmètre (120) et un deuxième capteur de température (130),
le deuxième ampèremètre (110) comporte un deuxième magnétomètre (115) et un deuxième dispositif de mesure de courant (118), le deuxième magnétomètre (115) est électriquement relié au deuxième dispositif de mesure de courant (118) et le deuxième dispositif de mesure de courant (118) est configuré pour transmettre un deuxième signal de courant (119) fonction du courant détecté par le deuxième magnétomètre (115),
le deuxième voltmètre (120) comporte une première borne de deuxième contact (122), une deuxième borne de deuxième contact (124) et un deuxième dispositif de mesure de tension (128), la première borne de deuxième contact (122) et la deuxième borne de deuxième contact (124) sont chacune électriquement reliées au deuxième dispositif de mesure de tension (128), le deuxième dispositif de mesure de tension (128) est configuré pour transmettre un deuxième signal de tension (129) fonction de la différence de potentiel entre la première borne de deuxième contact (122) et la deuxième borne de deuxième contact (124),
le deuxième capteur de température (130) est configuré pour transmettre un deuxième signal de température (139) fonction de la température,
le boitier (50) présente un deuxième logement (56) dans lequel est reçu le deuxième magnétomètre (115), le deuxième logement (56) est destiné à être reçu dans un deuxième trou de mesure (85) de la deuxième barre d'interconnexion (84), le deuxième logement (56) présente une deuxième surface extérieure (57) électriquement isolante, et
le module (1) comprend en outre un premier organe de deuxième fixation (152) et un deuxième organe de deuxième fixation (154), le premier organe de deuxième fixation (152) est configuré pour fixer le boitier (50) sur la première barre d'interconnexion (82) et maintenir la première borne de deuxième contact (122) électriquement au contact de la première barre d'interconnexion (82), le deuxième organe de deuxième fixation (154) est configuré pour fixer le boitier (50) sur la deuxième barre d'interconnexion (84) et maintenir la deuxième borne de deuxième contact (124) électriquement au contact de la deuxième barre d'interconnexion (84).

7. Ensemble (80) comprenant le module (1) selon l'une quelconque des revendications précédentes, la première barre d'interconnexion (82) et la deuxième barre d'interconnexion (84), dans lequel :
la première barre d'interconnexion (82) comporte le trou de mesure (83), dans lequel est disposé le magnétomètre (15), le logement (58) est disposé entre le magnétomètre (15) et la première barre d'interconnexion (82),
le premier organe de fixation (52) fixe le boitier (50) sur la première barre d'interconnexion (82) et maintient la première borne de contact (22) au contact de la première barre d'interconnexion (82), et
le deuxième organe de fixation (54) fixe le boitier (50) sur la deuxième barre d'interconnexion (84) et maintient la deuxième borne de contact (24) au contact de la deuxième barre d'interconnexion (84).

8. Ensemble selon la revendication précédente dans lequel :
le premier organe de fixation (52) comprend une première vis de fixation comportant une première tête de vis (52a) et une première portion filetée (52b), la première portion filetée (52b) est vissée dans la première barre d'interconnexion (82) et la première borne de contact (22) est pressée entre la première tête de vis (52a) et la première barre d'interconnexion (82), et
le deuxième organe de fixation (54) comprend une deuxième vis de fixation comportant une deuxième tête de vis (54a) et une deuxième portion filetée (54b), la deuxième portion filetée (54b) est vissée dans la deuxième barre d'interconnexion (84) et la deuxième borne de contact (24) est pressée entre la deuxième tête de vis (54a) et la deuxième barre d'interconnexion (84).

9. Ensemble (80) selon l'une quelconque des revendications 7 et 8 dans lequel l'ensemble (80) comprend en outre la batterie (90), la batterie (90) comporte une première borne (92) et une deuxième borne (94), la première borne (92) est électriquement reliée à la première barre d'interconnexion (82) et la deuxième borne (84) est électriquement reliée à la deuxième barre d'interconnexion (84).

10. Aéronef (100) comprenant un ensemble (80) selon la revendication précédente, un organe de commande (102) et un groupe motopropulseur (104) électriquement alimenté par la batterie (90), par l'intermédiaire de l'organe de commande (102).

## Patentansprüche

1. Modul (1) zur Erfassung eines Batterieladezustands, umfassend ein Gehäuse (50) und eine Unterbaugruppe (70), wobei die Unterbaugruppe ein Amperemeter (10), ein Voltmeter (20) und einen Temperatursensor (30) umfasst, wobei
das Gehäuse (50) dazu bestimmt ist, an einer ersten Verbindungsschiene (82) und einer zweiten Verbindungsschiene (84) befestigt zu werden, die von einer Batterie (90) gespeist werden, wobei die Unterbaugruppe (70) am Gehäuse (50) gehalten wird,
das Amperemeter (10) ein Magnetometer (15) und eine Strommesseinrichtung (18) umfasst, wobei das Magnetometer (12) elektrisch mit der Strommesseinrichtung (18) verbunden ist und die Strommesseinrichtung (18) dazu ausgelegt ist, ein Stromsignal (19) in Abhängigkeit von einem vom Magnetometer (15) erfassten Strom zu übertragen,
das Voltmeter (20) einen ersten Kontaktanschluss (22), einen zweiten Kontaktanschluss (24) und eine Spannungsmesseinrichtung (28) umfasst, wobei der erste Kontaktanschluss (22) und der zweite Kontaktanschluss (24) jeweils elektrisch mit der Spannungsmesseinrichtung (28) verbunden sind, wobei die Spannungsmesseinrichtung (28) dazu ausgelegt ist, ein Spannungssignal (29) in Abhängigkeit von der Potentialdifferenz zwischen dem ersten Kontaktanschluss (22) und dem zweiten Kontaktanschluss (24) zu übertragen,
der Temperatursensor (30) dazu ausgelegt ist, ein Temperatursignal (39) in Abhängigkeit von der Temperatur zu übertragen,
das Gehäuse (50) eine Aufnahme (58) aufweist, in der das Magnetometer (15) aufgenommen ist,
die Aufnahme (52) dazu bestimmt ist, in einer Messbohrung (83) der ersten Verbindungsschiene (82) aufgenommen zu werden, wobei die Aufnahme (58) eine elektrisch isolierende Außenfläche (59) aufweist,
das Modul (1) ferner ein erstes Befestigungselement (52) und ein zweites Befestigungselement (54) umfasst, wobei das erste Befestigungselement (52) dazu ausgelegt ist, das Gehäuse (50) an der ersten Verbindungsschiene (82) zu befestigen und den ersten Kontaktanschluss (22) in elektrischem Kontakt mit der ersten Verbindungsschiene (82) zu halten, wobei das zweite Befestigungselement (54) dazu ausgelegt ist, das Gehäuse (50) an der zweiten Verbindungsschiene (84) zu befestigen und den zweiten Kontaktanschluss (24) in elektrischem Kontakt mit der zweiten Verbindungsschiene (84) zu halten.

2. Modul nach Anspruch 1,
wobei das Modul (1) ferner einen Mikrocontroller (40) umfasst, der Mikrocontroller (40) elektrisch mit dem Amperemeter (10), dem Voltmeter (20) und dem Temperatursensor (30) verbunden ist, um das Stromsignal (19), das Spannungssignal (29) und das Temperatursignal (39) zu empfangen, und der Mikrocontroller (40) dazu ausgelegt ist, ein Ausgangssignal (49) in Abhängigkeit vom Stromsignal (19), vom Spannungssignal (29) und vom Temperatursignal (39) auszugeben.

3. Modul nach dem vorstehenden Anspruch,
wobei das Modul (1) ferner einen Steckverbinder (60) umfasst, der Steckverbinder (60) am Gehäuse (50) gehalten wird und der Steckverbinder (60) elektrisch mit dem Mikrocontroller (40) verbunden ist, um das Ausgangssignal (49) zu empfangen.

4. Modul nach einem der vorstehenden Ansprüche,
wobei das Gehäuse (50) einen Innenraum (55) aufweist, der das Amperemeter (10), das Voltmeter (20) und den Temperatursensor (30) umschließt.

5. Modul nach einem der vorstehenden Ansprüche,
wobei die Aufnahme (58) aus einem rohrförmigen Abschnitt aus elektrisch isolierendem Material gebildet ist.

6. Modul nach einem der vorstehenden Ansprüche,
wobei
die Unterbaugruppe eine erste Unterbaugruppe bildet,
das Modul (1) eine zweite Unterbaugruppe (170) umfasst, die sich von der ersten Unterbaugruppe (70) unterscheidet, wobei die zweite Unterbaugruppe (170) am Gehäuse (50) gehalten wird und ein zweites Amperemeter (110), ein zweites Voltmeter (120) sowie einen zweiten Temperatursensor (130) umfasst,
das zweite Amperemeter (110) ein zweites Magnetometer (115) und eine zweite Strommesseinrichtung (118) umfasst, wobei das zweite Magnetometer (115) elektrisch mit der zweiten Strommesseinrichtung (118) verbunden ist und die zweite Strommesseinrichtung (118) dazu ausgelegt ist, ein zweites Stromsignal (119) in Abhängigkeit von dem vom zweiten Magnetometer (115) erfassten Strom zu übertragen,
das zweite Voltmeter (120) einen ersten Anschluss (122) des zweiten Kontakts, einen zweiten Anschluss (124) des zweiten Kontakts und eine zweite Spannungsmesseinrichtung (128) aufweist, wobei der erste Anschluss (122) des zweiten Kontakts und der zweite Anschluss (124) des zweiten Kontakts jeweils elektrisch mit der zweiten Spannungsmesseinrichtung (128) verbunden sind, die zweite Spannungsmesseinrichtung (128) dazu ausgelegt ist, ein zweites Spannungssignal (129) in Abhängigkeit von der Potentialdifferenz zwischen dem ersten Anschluss (122) des zweiten Kontakts und dem zweiten Anschluss (124) des zweiten Kontakts zu übertragen,
der zweite Temperatursensor (130) dazu ausgelegt ist, ein zweites Temperatursignal (139) in Abhängigkeit von der Temperatur zu übertragen,
das Gehäuse (50) eine zweite Aufnahme (56) aufweist, in der das zweite Magnetometer (115) aufgenommen ist, die zweite Aufnahme (56) dazu bestimmt ist, in einer zweiten Messbohrung (85) der zweiten Verbindungsschiene (84) aufgenommen zu werden, die zweite Aufnahme (56) eine zweite, elektrisch isolierende Außenfläche (57) aufweist, und
das Modul (1) ferner ein erstes Befestigungselement (152) für die zweite Befestigung und ein zweites Befestigungselement (154) für die zweite Befestigung umfasst, wobei das erste Befestigungselement (152) für die zweite Befestigung dazu ausgelegt ist, das Gehäuse (50) an der ersten Verbindungsschiene (82) zu befestigen und den ersten Anschluss (122) des zweiten Kontakts in elektrischem Kontakt mit der ersten Verbindungsschiene (82) zu halten, wobei das zweite Befestigungselement (154) für die zweite Befestigung dazu ausgelegt ist, das Gehäuse (50) an der zweiten Verbindungsschiene (84) zu befestigen und den zweiten Anschluss (124) des zweiten Kontakts in elektrischem Kontakt mit der zweiten Verbindungsschiene (84) zu halten.

7. Anordnung (80), umfassend das Modul (1) nach einem der vorstehenden Ansprüche, die erste Verbindungsschiene (82) und die zweite Verbindungsschiene (84), wobei
die erste Verbindungsschiene (82) die Messbohrung (83) aufweist, in der das Magnetometer (15) angeordnet ist, wobei die Aufnahme (58) zwischen dem Magnetometer (15) und der ersten Verbindungsschiene (82) angeordnet ist, das erste Befestigungselement (52) das Gehäuse (50) an der ersten Verbindungsschiene (82) befestigt und den ersten Kontaktanschluss (22) in Kontakt mit der ersten Verbindungsschiene (82) hält, und
das zweite Befestigungselement (54) das Gehäuse (50) an der zweiten Verbindungsschiene (84) befestigt und den zweiten Kontaktanschluss (24) in Kontakt mit der zweiten Verbindungsschiene (84) hält.

8. Anordnung nach dem vorstehenden Anspruch, wobei
das erste Befestigungselement (52) eine erste Befestigungsschraube mit einem ersten Schraubenkopf (52a) und einem ersten Gewindeabschnitt (52b) umfasst, wobei der erste Gewindeabschnitt (52b) in die erste Verbindungsschiene (82) eingeschraubt ist und der erste Kontaktanschluss (22) zwischen dem ersten Schraubenkopf (52a) und der ersten Verbindungsschiene (82) eingepresst ist, und
das zweite Befestigungselement (54) eine zweite Befestigungsschraube mit einem zweiten Schraubenkopf (54a) und einem zweiten Gewindeabschnitt (54b) umfasst, wobei der zweite Gewindeabschnitt (54b) in die zweite Verbindungsschiene (84) eingeschraubt ist und der zweite Kontaktanschluss (24) zwischen dem zweiten Schraubenkopf (54a) und der zweiten Verbindungsschiene (84) eingepresst ist.

9. Anordnung (80) nach einem der Ansprüche 7 und 8,
wobei die Anordnung (80) ferner die Batterie (90) umfasst, die Batterie (90) einen ersten Anschluss (92) und einen zweiten Anschluss (94) aufweist, der erste Anschluss (92) elektrisch mit der ersten Verbindungsschiene (82) verbunden ist und der zweite Anschluss (84) elektrisch mit der zweiten Verbindungsschiene (84) verbunden ist.

10. Luftfahrzeug (100), umfassend eine Anordnung (80) nach dem vorstehenden Anspruch, eine Steuereinheit (102) und ein Triebwerk (104), das über die Steuereinheit (102) elektrisch von der Batterie (90) gespeist wird.

## Claims

1. A module (1) for detecting a level of charge of a battery, comprising a housing (50) and a subassembly (70), said subassembly comprising an ammeter (10), a voltmeter (20), and a temperature sensor (30), wherein:
the housing (50) is intended to be attached to a first interconnection bar (82) and a second interconnection bar (84) which are powered by a battery (90), the subassembly (70) being held in the housing (50),
the ammeter (10) comprises a magnetometer (15) and a current-measuring device (18), the magnetometer (15) being electrically connected to the current-measuring device (18) and the current-measuring device (18) being configured to transmit a current signal (19) that is based on the current detected by the magnetometer (15),
the voltmeter (20) comprises a first contact terminal (22), a second contact terminal (24), and a voltage-measuring device (28), the first contact terminal (22) and the second contact terminal (24) each being electrically connected to the voltage-measuring device (28), the voltage-measuring device (28) being configured to transmit a voltage signal (29) that is based on the potential difference between the first contact terminal (22) and the second contact terminal (24),
the temperature sensor (30) is configured to transmit a temperature signal (39) that is based on the temperature,
the housing (50) has a receptacle (58) in which the magnetometer (15) is received, the receptacle (58) being intended to be received in a measurement hole (83) of the first interconnection bar (82), the receptacle (58) having an electrically insulating outer surface (59),
the module (1) further comprises a first attachment member (52) and a second attachment member (54), the first attachment member (52) being configured to attach the housing (50) to the first interconnection bar (82) and to hold the first contact terminal (22) in electrical contact with the first interconnection bar (82), the second attachment member (54) being configured to attach the housing (50) to the second interconnection bar (84) and to hold the second contact terminal (24) in electrical contact with the second interconnection bar (84).

2. Module according to claim 1 wherein the module (1) further comprises a microcontroller (40), the microcontroller (40) being electrically connected to the ammeter (10), the voltmeter (20), and the temperature sensor (30) in order to receive the current signal (19), the voltage signal (29), and the temperature signal (39), the microcontroller (40) being configured to emit an output signal (49) that is based on the current signal (19), the voltage signal (29), and the temperature signal (39).

3. Module according to the preceding claim wherein the module (1) further comprises a connector (60), the connector (60) being held on the housing (50) and the connector (60) being electrically connected to the microcontroller (40) in order to receive the output signal (49).

4. Module according to any one of the preceding claims, wherein the housing (50) has an internal space (55) enclosing the ammeter (10), the voltmeter (20), and the temperature sensor (30).

5. Module according to any one of the preceding claims, wherein the receptacle (58) is formed by a tubular portion made of electrically insulating material.

6. Module according to any one of the preceding claims, wherein:
the subassembly forms a first subassembly,
the module (1) comprises a second subassembly (170) that is distinct from the first subassembly (70), the second subassembly (170) being held in the housing (50) and comprising a second ammeter (110), a second voltmeter (120), and a second temperature sensor (130),
the second ammeter (110) comprises a second magnetometer (115) and a second current-measuring device (118), the second magnetometer (115) being electrically connected to the second current-measuring device (118) and the second current-measuring device (118) being configured to transmit a second current signal (119) that is based on the current detected by the second magnetometer (115),
the second voltmeter (120) comprises a first second contact terminal (122), a second second contact terminal (124), and a second voltage-measuring device (128), the first second contact terminal (122) and the second second contact terminal (124) each being electrically connected to the second voltage-measuring device (128), the second voltage-measuring device (128) being configured to transmit a second voltage signal (129) that is based on the potential difference between the first second contact terminal (122) and the second second contact terminal (124),
the second temperature sensor (130) is configured to transmit a second temperature signal (139) that is based on the temperature,
the housing (50) has a second receptacle (56) in which the second magnetometer (115) is received, the second receptacle (56) being intended to be received in a second measurement hole (85) of the second interconnection bar (84), the second receptacle (56) having a second electrically insulating outer surface (57), and
the module (1) further comprises a first second attachment member (152) and a second second attachment member (154), the first second attachment member (152) being configured to attach the housing (50) to the first interconnection bar (82) and to hold the first second contact terminal (122) in electrical contact with the first interconnection bar (82), the second second attachment member (154) being configured to attach the housing (50) to the second interconnection bar (84) and to hold the second second contact terminal (124) in electrical contact with the second interconnection bar (84).

7. An assembly (80) comprising the module (1) according to any one of the preceding claims, the first interconnection bar (82), and the second interconnection bar (84), wherein:
the first interconnection bar (82) comprises the measurement hole (83), in which the magnetometer (15) is arranged, the receptacle (58) being arranged between the magnetometer (15) and the first interconnection bar (82),
the first attachment member (52) attaches the housing (50) to the first interconnection bar (82) and holds the first contact terminal (22) in contact with the first interconnection bar (82), and
the second attachment member (54) attaches the housing (50) to the second interconnection bar (84) and holds the second contact terminal (24) in contact with the second interconnection bar (84).

8. Assembly according to the preceding claim, wherein:
the first attachment member (52) comprises a first attachment screw having a first screw head (52a) and a first threaded portion (52b), the first threaded portion (52b) being screwed into the first interconnection bar (82) and the first contact terminal (22) being pressed between the first screw head (52a) and the first interconnection bar (82), and
the second attachment member (54) comprises a second attachment screw having a second screw head (54a) and a second threaded portion (54b), the second threaded portion (54b) being screwed into the second interconnection bar (84) and the second contact terminal (24) being pressed between the second screw head (54a) and the second interconnection bar (84).

9. Assembly (80) according to either of claims 7 and 8 wherein the assembly (80) further comprises the battery (90), the battery (90) comprising a first terminal (92) and a second terminal (94), the first terminal (92) being electrically connected to the first interconnection bar (82) and the second terminal (84) being electrically connected to the second interconnection bar (84).

10. An aircraft (100) comprising an assembly (80) according to the preceding claim, a control member (102), and a powertrain (104) that is electrically powered by the battery (90) via the control member (102).
